# NEUE EUROPÄISCHE PATENTSCHRIFT

(11) **EP 1 380 056 B2**
(45) Veröffentlichungstag und Bekanntmachung des Hinweises auf die Entscheidung über den Einspruch: **09.07.2014**
(45) Hinweis auf die Patenterteilung: 23.05.2007
(21) Anmeldenummer: 02732539.8
(22) Anmeldetag: 30.03.2002
(51) Int. Cl.: H01L 31/0203, H01L 33/52

(54) **OPTOELEKTRONISCHE BAUELEMENTANORDNUNG UND VERFAHREN ZUR HERSTELLUNG EINER OPTOELEKTRONISCHEN BAUELEMENTANORDNUNG**
OPTOELECTRONIC COMPONENT ARRAY AND METHOD FOR THE PRODUCTION OF AN OPTOELECTRONIC COMPONENT ARRAY
ENSEMBLE COMPOSANT OPTOELECTRONIQUE ET PROCEDE DE FABRICATION D'UN ENSEMBLE COMPOSANT OPTOELECTRONIQUE

(30) Priorität: 11.04.2001 DE 10118231
(43) Veröffentlichungstag der Anmeldung: 14.01.2004
(73) Patentinhaber: Dr. Johannes Heidenhain GmbH, 83292 Traunreut (DE)
(72) Erfinder: RISSING, Lutz, 83358 Seebruck (DE); OBERMAYER, Florian, 83329 Waging am See (DE); SCHROLL, Florian, 83370 Seeon (DE)
(86) Internationale Anmeldenummer: PCT/EP2002/003564
(87) Internationale Veröffentlichungsnummer: WO 2002/084746

(56) Entgegenhaltungen:
- EP-A- 0 632 508
- WO-A-01/24281
- DE-A- 10 023 353
- DE-A- 10 024 336
- DE-A- 19 755 734
- PATENT ABSTRACTS OF JAPAN vol. 007, no. 115 (E-176), 19. Mai 1983 (1983-05-19) & JP 58 034681 A (HITACHI SEISAKUSHO KK), 1. März 1983 (1983-03-01)

## Beschreibung

Die vorliegende Erfindung betrifft eine optoelektronische Bauelementanordnung. Desweiteren betrifft die vorliegende Erfindung ein Verfahren zur Herstellung einer optoelektronischen Bauelementanordnung.

Eine optoelektronische Bauelementanordnung ist aus der JP 8-241976 bekannt. Auf einem Trägerelement ist ein als CCD-Chip ausgebildetes optoelektronisches Bauelement angeordnet, das von einem Damm ringförmig umgeben ist. Das Bauelement ist über Bonddrähte mit Leitungen im Trägerelement verbunden und wird derart elektrisch kontaktiert. Im Damm-Innenbereich ist ein Verguss angeordnet, der aus zwei transparenten Vergussmaterialien besteht. Aufgrund thermisch induzierter Spannungen können Risse im Verguss auftreten und ggf. die Bonddrähte beschädigen. Es wird daher vorgeschlagen, in einem ersten Schritt ein erstes transparentes Vergussmaterial in den Damm-Innenbereich einzubringen, dieses thermisch auszuhärten und dabei Luftblasen aus dem Vergussmaterial zu eliminieren. Anschließend wird in einem zweiten Verfahrensschritt eine zweite transparente Vergussmasse in den Damm-Innenbereich eingebracht und wiederum thermisch ausgehärtet, um eventuelle Luftblasen im zweiten Vergussmaterial zu beseitigen. Auf diese Art und Weise lässt sich gewährleisten, dass keine Luftblasen mehr in den beiden Vergussmaterialien enthalten sind. Werden in einer derartigen Bauelementanordnung nunmehr Materialien mit stark voneinander abweichenden thermischen Ausdehnungskoeffizienten verwendet, können unter thermischen Belastungen Bonddraht-Risse auftreten. Deutlich unterschiedliche thermische Ausdehnungskoeffizienten weisen etwa die einerseits verwendeten transparenten Vergussmaterialien bzw. Epoxidharze (α ≈ 50 - 70 ppm/K) und andererseits die eingesetzten Materialien für das Trägerelement bzw. die Bonddrähte (α ≈ 15 - 25 ppm/K) auf.

Weitere optoelektronische Bauelementanordnungen sind aus der WO 01/24281 A1 bekannt. Die in dieser Druckschrift in Fig. 4 offenbarte Bauelementanordnung sieht hierbei ebenfalls zwei verschiedene Vergussmaterialien vor, die zum einen den Damm-Innebreich ausfüllen und zum anderen die gesamte Bauelementanordnung überdecken. Dadurch wird zwar die thermomechanische Spannungsentlastung des optoelektronischen Bauelements verbessert, jedoch ist aufgrund der Anordnung der beiden Vergussmaterialien nach wie vor erforderlich, dass beide Materialien teiltransparent sind. Dies schränkt die, Wahl optimal angepasster Vergussmaterialien ein, so dass letztlich keine ideale Anpassung in Bezug auf die thermischen Ausdehnungskoeffizienten möglich ist.

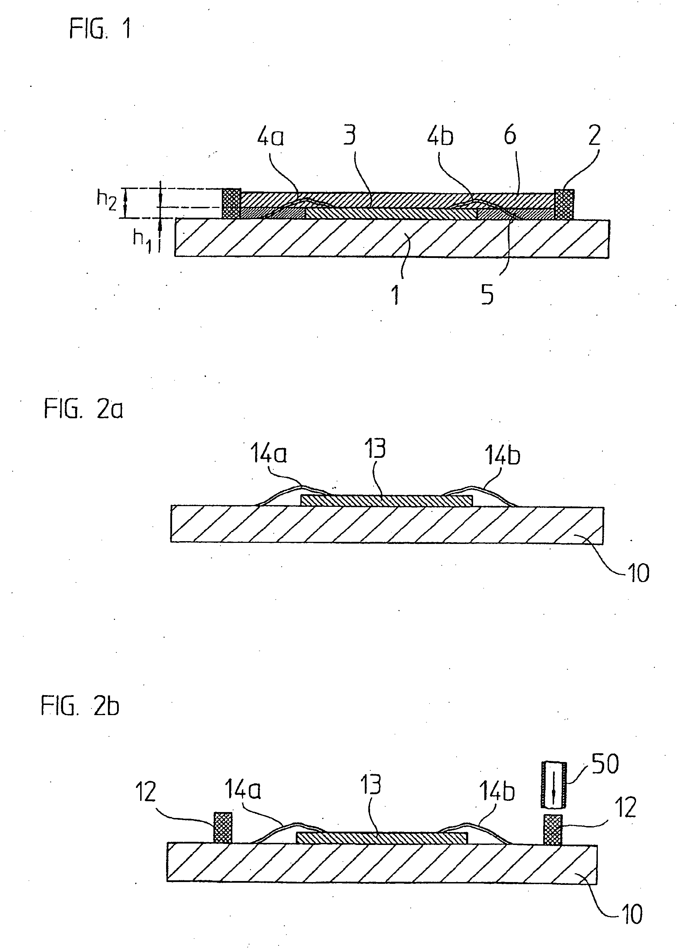

Aus der US 5,861,680 sind verschiedene optoelektronische Bauelementanordnungen bekannt, bei denen jeweils ein optoelektrisches Bauelement auf einem Trägerelement von einem Damm oder Rahmen umgeben ist, wobei das Bauelement über Bonddrähte elektrisch kontaktiert wird. Der Innenbereich des Damms bzw. Rahmens ist mit einem transparenten Vergussmaterial ausgefüllt. Die Beispiele aus den Figuren 1A und 1B unterscheiden sich hierbei lediglich in Bezug auf die Anordnung z.B. auf einer Platine bzw. durch die jeweilige Kontaktierungsmöglichkeit; so offenbart Fig. 1A eine sog. DIP-Anordnung, die zur Durchsteckmontage geeignet ist, in Fig. 1B ist eine LCC-Anordnung gezeigt, welche zur SMD-Bestückung geeignet ist. Ein temperaturbedingtes Beschädigen der Bonddrähte soll gemäß dieser Druckschrift dadurch verhindert werden, dass die Härte des Vergussmaterials während der Fertigung geeignet eingestellt wird.

Aus der EP 0 632 508 A2 ist eine Photodetektoranordnung mit einem Mehrschichtfilter sowie ein Verfahren zu deren Herstellung bekannt. Bei dem in Figur 12 dargestellten Ausführungsbeispiel ist in einer Vertiefung eines Trägerelements ein Photodetektorelement platziert, welches mittels Bonddrähten kontaktiert wird. Innerhalb der Vertiefung ist ein erstes nichttransparentes Vergussmaterial benachbart zum Photodetektorelement angeordnet, darüber ein zweites transparentes Vergussmaterial. Nachteilig an dieser Anordnung ist insbesondere, dass eine aufwendige formgebende Bearbeitung des Trägerelements nötig ist, um die Vertiefung auszubilden.

Aufgabe der vorliegenden Erfindung ist es daher, eine optoelektronische Bauelementanordnung sowie ein geeignetes Verfahren zu deren Herstellung anzugeben, worüber sichergestellt ist, dass die zur Kontaktierung des optoelektronischen Baulementes vorgesehenen Bonddrähte auch bei variierenden Temperaturen nicht beschädigt werden.

Die erste, angegebene Aufgabe wird gelöst durch eine optoelektronische Bauelementanordnung mit den Merkmalen des Anspruches 1.

Vorteilhafte Ausführungsformen der erfindungsgemäßen optoelektronischen Bauelementanordnung ergeben sich aus den Maßnahmen, die in den von Anspruch 1 abhängigen Patentansprüchen aufgeführt sind:

Die zweite aufgeführte Aufgabe wird durch ein Verfahren zur Herstellung einer optoelektronischen Bauelementanordnung gemäß den Maßnahmen des Anspruches 9 gelöst.

Vorteilhafte Ausführungsformen des erfindungsgemäßen Verfahrens ergeben sich aus den Maßnahmen, die in den von Anspruch 9 abhängigen Patentansprüchen aufgeführt sind.

Erfindungsgemäß wird nunmehr ein erstes Vergussmaterial in den Damm-Innenbereich eingebracht, wobei das erste Vergussmaterial vorteilhafterweise bis zur Oberkante des optoelektronischen Bauelementes reicht. Zumindest in einem räumlich definierten Fensterbereich wird darüber ein transparentes zweites Vergussmaterial eingebracht. Das erste Vergussmaterial wird vorzugsweise unterschiedlich, zum transparenten zweiten Vergussmaterial gewählt. Insbesondere wird bei der Wahl, des ersten Vergussmateriales berücksichtigt, dass dieses einen möglichst niedrigen thermischen Ausdehnungskoeffizienten aufweist, der an den thermischen Ausdehnungskoeffizienten der verwendeten Bonddrähte und des verwendeten Trägerelementes angepasst ist. Auf diese Art und

Weise lassen sich thermisch induzierte Spannungen im Bereich der Bonddrähte und damit ein unerwünschtes Reissen derselben vermeiden.

Weiterhin vorteilhaft erweist sich, wenn bei der Wahl des ersten Vergussmateriales ein Material gewählt wird, das im ausgehärteten Zustand eine möglichst rauhe Oberfläche besitzt. Derart ist eine gute Haftung des darüber angeordneten zweiten Vergussmateriales sichergestellt, die zudem gewährleistet, dass es zu keinen thermisch verursachten Verscherungsbewegungen zwischen den beiden Vergussmaterialien kommt, die ggf. die Bonddrähte beschädigen könnten. Bei der Wahl des ersten Vergussmateriales müssen zudem nicht mehr dessen optische Eigenschaften berücksichtigt werden, d.h. die Materialwahl kann allein unter den oben angeführten Optimierungskriterien erfolgen.

Ein besonderer herstellungstechnischer Vorteil resultiert in einer möglichen Ausführungsform des erfindungsgemäßen Verfahrens, wenn das erste Vergussmaterial und das Damm-Material aus dem im wesentlich gleichen Grundmaterial bestehen und lediglich unterschiedliche Viskositäten besitzen, da dann das erste Vergussmaterial und der Damm im gleichen Arbeitsschritt aufgebracht und ausgehärtet werden können.

Weitere Vorteile sowie Einzelheiten der vorliegenden Erfindung ergeben sich aus der nachfolgenden Beschreibung von Ausführungsbeispielen anhand der beiliegenden Figuren.

Dabei zeigt
- Figur 1: eine schematisierte Schnittansicht eines ersten Ausführungsbeispieles der erfindungsgemäßen optoelektronischen Bauelementanordnung;
- Figur 2a - 2e: jeweils einen Verfahrensschritt im Rahmen des erfindungsgemäßen Verfahrens zur Herstellung einer zweiten Ausführungsform der erfindungsgemäßen optoelektronischen Bauelementanordnung.

In Figur 1 ist eine schematisierte, seitliche Schnittansicht einer ersten Ausführungsform der erfindungsgemäßen optoelektronischen Bauelementanordnung dargestellt. Hierbei sind auf einem Trägerelement 1 die weiteren, nachfolgend zu erläuternden Komponenten der Bauelementanordnung angeordnet. Das Trägerelement 1 ist in diesem Beispiel als bekannte Leiterplatte aus FR4-Material ausgebildet. Alternativ kommen jedoch auch andere Materialien für das Trägerelement 1 in Betracht, wie etwa FR5, Aluminiumoxid, Glas etc..

Nicht erkennbar sind in Figur 1 die im Trägerelement 1 verlaufenden Leitungen, die zur elektrischen Kontaktierung des auf dem Trägerelement 1 angeordneten optoelektronischen Bauelementes 3 und eventueller weiterer Bauelemente dienen. Als optoelektronisches Bauelement 3 ist im dargestellten Ausführungsbeispiel ein ungehäustes Bauelement 3 in Form eines Fotodetektors vorgesehen, dessen strahlungsempfindliche Fläche vom Trägerelement 1 weg orientiert ist. Alternativ hierzu könnte auch eine entsprechende ungehäuste Lichtquelle, ein sog. Opto-ASIC oder ein sonstiges Optoelektronik-Element als optoelektronisches Bauelement 3 an dieser Stelle zum Einsatz kommen.

Das jeweilige optoelektronische Bauelement 3 wird mittels Bonddrähten 4a, 4b mit den elektrischen Leitungen im Trägerelement 1 verbunden bzw. über die Bonddrähte 4a, 4b in bekannter Art und Weise elektrisch kontaktiert. Als Material wird für die Bonddrähte 4a, 4b im vorliegenden Beispiel Gold verwendet. Darüberhinaus sind auch Gold-Legierungen, Aluminium, AluminiumLegierungen oder aber Kupfer als Bonddraht-Materialien einsetzbar.

Das optoelektronische Bauelement 2 ist im dargestellten Ausführungsbeispiel auf dem Trägerlement 1 aufgeklebt; alternativ könnte diese Verbindung auch durch Legieren, Eutektisches Bonden, Anodisiertes Bonden, Löten oder aber Schweißen hergestellt werden.

Desweiteren umfasst die erfindungsgemäße optoelektronische Bauelementanordnung einen auf dem Trägerelement 1 angeordneten Damm 2, der das Bauelement 3 geschlossen umgibt bzw. umläuft. Der Damm 2 kann verschiedenste Umlaufgeometrien aufweisen; beispielsweise kann der Damm 2 das Bauelement 3 quadratisch umgeben, alternativ kann aber auch ein rechteckförmiger, vieleckförmiger oder runder Dammverlauf um das Bauelement 3 vorgesehen sein.

Der Damm 2 weist eine Höhe h₂ auf, die im vorliegenden Beispiel deutlich größer als die Höhe h₁ des Bauelementes 3 gewählt ist. Typische Werte für die Höhen h₁, h₂ betragen etwa h₁ = 450µm und h₂= 800µm.

Eine wesentliche Funktion des Dammes 2 besteht in der erfindungsgemä-ßen Bauelementanordnung darin, dass darüber die benötigte Fläche auf dem Trägerelement 1 begrenzt wird, die zum Vergießen des Bauelementes 3 im Damm-Innenbereich mit einem Verguss erforderlich ist. Erfindungsgemäß werden zum Vergießen zwei Vergussmaterialien 5, 6 verwendet, wie nachfolgend noch detailliert erläutert wird. Das Vergießen der Bauelementanordnung mit der beiden Vergussmaterialien 5, 6 dient zum Schutz des Bauelementes 3 sowie der Bonddrähte 4a, 4b gegenüber mechanischen Einflüssen.

Als geeignetes Damm-Material kann eine bekannte schwarze Epoxyfüllmasse in Form eines gefüllten Epoxidharzes vorgesehen werden, wie sie von der Firma *Emerson & Cuming* unter der Typenbezeichnung *Amicon 50300 HT* vertrieben wird. Alternativ können auch Epoxyfüllmassen der Firma *Dexter Hysol* verwendet werden, die unter den Produktbezeichnungen *FP 4451* vertrieben werden.

Der Damm 2 besteht im vorliegenden Ausführungsbeispiel aus einer einzigen Dammschicht, wie dies in Figur 1 ersichtlich ist. Alternativ könnte jedoch auch ein zwei- oder mehrschichtiger Dammaufbau vorgesehen werden, wie dies z.B. in der deutschen Patentanmeldung Nr. 100 24 336.3 beschrieben ist. Desweiteren wäre es alternativ möglich, den Damm 2 als Spritzgussteil auszubilden.

Wesentlich für die vorliegende Erfindung ist nunmehr, dass der im wannenartigen Damm-Innenbereich angeordnete Verguss, der das optoelektronische Bauelement 3 umkapselt, aus zwei verschiedenen Vergussmaterialien 5, 6 besteht. Hierbei ist im dargestellten Beispiel der Damm-Innenbereich bis zur Oberkante des optoelektronischen Bauelementes 3 mit einem ersten Vergussmaterial 5 gefüllt. Das erste Vergussmaterial 5 weist im dargestellten Beispiel demzufolge eine Höhe auf, die der Höhe h₁ des Bauelementes 3 entspricht. Grundsätzlich sollte sichergestellt sein, dass der Damm-Innenbereich bis zur Oberkante des optoelektronischen Bauelementes 3 mit dem ersten Vergussmaterial gefüllt ist und demzufolge auch die strahlungsempfindliche oder ggf. strahlungsemittierende Fläche des optoelektronischen Bauelementes 3 nicht wesentlich vom ersten Vergussmaterial 5 bedeckt ist.

Das erste Vergussmaterial 5 wird erfindungsgemäß derart gewählt, dass dessen thermischer Ausdehnungskoeffizient α_{VM1} an den thermischen Ausdehnungskoeffizienten der Bonddrähte 4a, 4b (α_{BD}) und des Trägerelementes 1 (α_{TE}) angepasst ist. Hierzu wird beispielsweise eine schwarze Epoxyfüllmasse verwendet, die einen thermischen Ausdehnungskoeffizienten α_{VM1} ≈ 18 - 19 ppm/K aufweist. Damit ist gegenüber dem thermischen Ausdehnungskoeffizienten α_{BD} ≈ 15 ppm/K der Bonddrähte 4a, 4b bereits eine sehr gute Anpassung erreicht, wenn als Material für die Bonddrähte 4a, 4b Gold verwendet wird. Auch die anderen, oben bereits erwähnten Materialien für die Bonddrähte 4a, 4b weisen thermische Ausdehnungskoeffizienten im Bereich α_{BD} ≈ [15 ppm/K - 25 ppm/K] auf. Ebenso liegt im Fall der Verwendung von FR4 als Material für das Trägerelement 1 eine gute Anpassung an dessen thermischen Ausdehnungskoeffizienten α_{TE} ≈ 15 ppm/K vor. Geeignete erste Vergussmaterialien 5 werden z.B. von den Firma *Emerson & Cuming* oder *Dexter Hysol* unter den Produktbezeichnung *Amicon* 50500-1 bzw. FP 4450 vertrieben.

Das erste Vergussmaterial 5 und das Material des Dammes 2 weisen in der erläuterten Ausführungsform demzufolge das gleiche Grundmaterial auf und besitzen lediglich unterschiedliche Viskositäten. Wie später noch erläutert wird, resultieren aus dieser Materialwahl auch Vorteile im Verlauf einer möglichen Ausführungsform des erfindungsgemäßen Herstellungsverfahrens.

Das erste Vergussmaterial 5 wird ferner derart gewählt, dass dieses im ausgehärteten Zustand eine möglichst große Oberflächenrauheit besitzt. Dadurch kann eine sehr gute Haftung mit dem darüber angeordneten Material, nämlich dem zweiten Vergussmaterial 6 sichergestellt werden. Beim zweiten Vergussmaterial 6 handelt es sich um ein handelsübliches transparentes Vergussmaterial, das im Damm-Innenbereich zumindest in einem Fensterbereich oberhalb des optoelektronischen Bauelementes 3 angeordnet ist, also beispielsweise im strahlungsempfindlichen Bereich des Fotoelementes etc.. Als geeignet erweist sich für das zweite Vergussmaterial 6 z.B. das von der Firma *Dexter Hysol* unter der Produktbezeichnung *Hysol OS 2800* vertriebene Produkt. Alternativ wären auch die unter den Produktbezeichnungen *Hysol OS 1600, Hysol OS 1900, Hysol OS 2902, Hysol OS 4000 oder Hysol OS 4110* von der gleichen Firma vertriebenen Vergussmaterialien an dieser Stelle verwendbar.

Im Beispiel der Figur 1 füllt das zweite Vergussmaterial 6 den Damm-Innenbereich über dem ersten Vergussmaterial 5 und dem optoelektronischen Bauelement 3 vollständig aus. Wie bereits erwähnt, könnte alternativ aber auch lediglich ein kleinerer Fensterbereich damit gefüllt werden.

Durch die erfindungsgemäße Anordnung und Wahl der Vergussmaterialien 5, 6 wird zum einen sichergestelt, dass das Gesamt-Füllvolumen im Damm-Innenbereich, welches mit dem transparenten, zweiten Vergussmaterial 6 gefüllt werden muss, deutlich reduziert werden kann. Wie oben erläutert resultierten die Probleme in Verbindung mit dem thermisch induzierten Abscheren der Bonddrähte 4a, 4b im wesentlichen aufgrund der stark differierenden thermischen Ausdehnungskoeffizienten transparenter Vergussmaterialien einerseits und der Bonddrähte 4a, 4b bzw. des Trägerelementes 1 andererseits. Das verringerte Füllvolumen wirkt sich auch dahingehend positiv aus, dass die auf den Schrumpfungsprozess beim Aushärten zurückgehenden Spannungen innerhalb der Bauelementanordnung reduziert werden. Desweiteren ist aufgrund der rauhen Oberflächenbeschaffenheit des ersten Vergussmateriales 5 gewährleistet, dass eine gute Verzahnung mit dem darüberliegenden zweiten Vergussmaterial 6 resultiert. Dadurch ist ein thermisch bedingtes Abscheren der beiden Vergussmaterialien 5, 6 gegeneinander und damit ein Reissen der Bonddrähte 4a, 4b praktisch nicht mehr möglich.

Neben der erläuterten ersten Ausführungsform einer optoelektronischen Bauelementanordnung existieren im Rahmen der vorliegenden Erfindung selbstverständlich noch alternative Ausführungsvarianten. Eine zweites Ausführungsbeispiel sei nachfolgend in Verbindung mit den Figuren 2a - 2e erläutert, anhand der auch eine mögliche Ausführungsform des erfindungsgemäßen Verfahrens beschrieben wird.
In einem ersten Prozessschritt, dargestellt in Figur 2a, wird zunächst das ungehäuste optoelektronische Bauelement 13 in Form eines Opto-ASICs auf dem Trägerelement 10 bzw. der Leiterplatte angeordnet und darauf verklebt. Ferner wird das optoelektronische Bauelement 13 elektrisch kontaktiert, was in bekannter Art und Weise über Drahtbonden und das Anordnen von entsprechenden Bonddrähten 14a, 14b erfolgen kann.

Nachfolgend wird der Damm 12 auf dem Trägerelement 10 mit der Höhe h₂ aufgebracht, der wie oben erläutert das optoelektronische Bauelement 13 vollständig umschließt. Der entsprechende Prozessschritt ist in Figur 2b veranschaulicht. Das Aufbringen des entsprechenden Damm-Materiales erfolgt in diesem Beispiel mit Hilfe einer schematisch angedeuteten Dosiernadel 50 in der sog. Dispense-Technik. Wie bereits erwähnt könnte alternativ auch ein als Spritzgussteil ausgebildeter Damm bzw. Rahmenelement auf das Trägerelement aufgesetzt werden.

Die gewünschte Höhe h₂ des Dammes 12 lässt sich im Fall der Aufbringung über die Dispense-Technik durch Abstimmen der Verfahrgeschwindigkeit der Dosiernadel 50, der aufgebrachten Menge des Damm-Materiales etc. definiert einstellen.

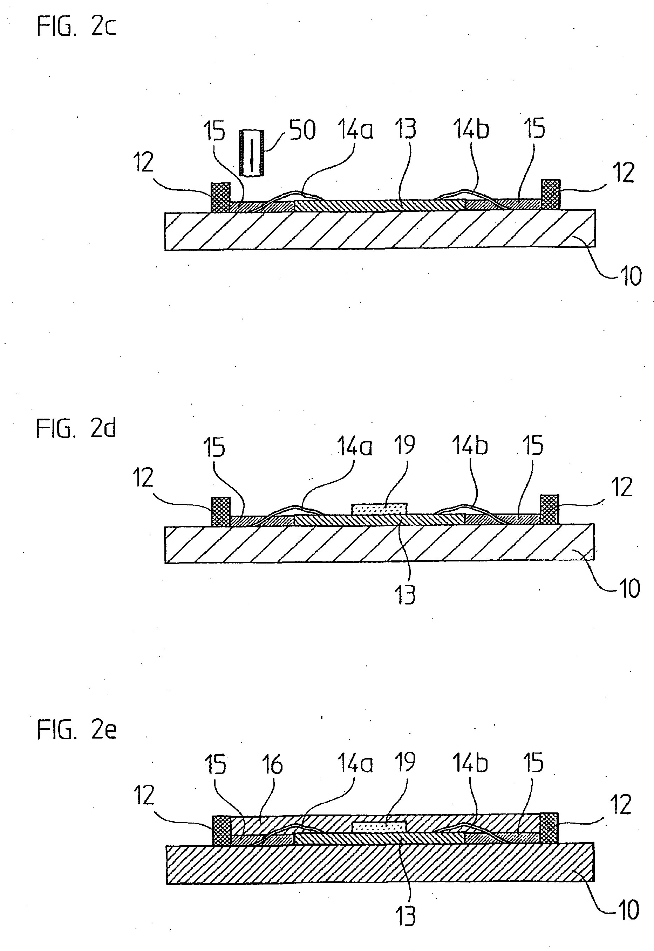

Im anschließenden Prozesschritt, dargestellt in Figur 2c, wird im Damm-Innenbereich mit Hilfe der Dosiernadel 50 bis zur Höhe h₁ der Bauelement-Oberkante ein erstes Vergussmaterial 15 eingebracht. Wie oben erläutert, wird in diesem Ausführungsbeispiel ein erstes Vergussmaterial 15 gewählt, das aus dem gleichen Grundmaterial wie der Damm 12 besteht. Beispielsweise kann hierzu ein schwarzes, gefülltes Epoxidharz bzw. eine Epoxyfüllmasse verwendet werden. Nachfolgend erfolgt über einen einen geeigneten Temperungs-Prozess das Aushärten des Dammes 12 als auch des ersten Vergussmateriales 15.

Im nachfolgenden Verfahrensschritt, der in Figur 2d dargestellt ist, wird im Unterschied zum ersten erläuterten Ausführungsbeispiel, eine zusätzliche Glasplatte 19 auf der strahlungsempfindlichen Fläche des Bauelementes 13 bzw. des Opto-ASICs angeordnet. Dies kann wie in Figur 2d angedeutet vor dem Auffüllen mit dem zweiten transparenten Vergussmaterial erfolgen; alternativ ist es aber auch möglich, die Glasplatte 19 erst nach dem restlichen Auffüllen des Damm-Innenbereiches mit dem transparenten zweiten Vergussmaterial auf die Oberfläche des Bauelementes 13 anzupressen.

Die Anordnung der Glasplatte 19 dient im Fall von Bauelementen 13 mit nicht-passivierten aktiven Flächen zum Schutz bzw. Versiegeln dieser Flächen. Wenn außerdem die Dicke der Glasplatte 19 groß genug gewählt wird, kann damit ein zusätzlicher mechanischer Schutz für die Bonddrähte 14a, 14b gewährleistet werden. Alternativ zum dargestellten Ausführungsbeispiel kann die Glasplatte selbstverständlich auch eine größere Dicke aufweisen und dann geringfügig aus dem zweiten Vergussmaterial herausragen.

Im nächsten Verfahrensschritt, dargestellt in Figur 2e, wird schließlich der verbleibende Damm-Innenbereich mit Hilfe der Dosiernadel 70 mit dem zweiten Vergussmaterial 16 bis etwa zur Damm-Oberkante gefüllt, wozu wie oben erläutert ein transparentes Vergussmaterial verwendet wird.

## Patentansprüche

1. Optoelektronische Bauelementanordnung, bestehend aus
- einem Trägerelement (1; 10),
- einem auf dem Trägerelement (1; 10) angeordneten optoelektronischen Bauelement (3; 13), das über Bonddrähte (4a, 4b; 14a, 14b) mit Leitungen im Trägerelement (1; 10) verbunden ist,
- einem geschlossenen Damm (2; 12) auf dem Trägerelement (1; 10), der das optoelektronische Bauelement (3; 13) umgibt,
- einem im Damm-Innenbereich angeordneten Verguss, der das optoelektronische Bauelement (3; 13) umkapselt und zwei Vergussmaterialien (5, 6; 15, 16) umfasst, wobei
- der Damm-Innenbereich oberhalb des optoelektronischen Bauelementes (3; 13) zumindest in einem Fensterbereich mit einem transparenten zweiten Vergussmaterial (6; 16) gefüllt ist und
- der Damm-Innenbereich bis zur Oberkante des optoelektronischen Bauelementes (3; 13) mit einem ersten nicht-transparenten Vergussmaterial (5; 15) gefüllt ist und
- die Bonddrähte (4a, 4b; 14a, 14b) an ihrem trägerelementseitigen Ende vom ersten Vergussmaterial (5; 15) umgeben sind und
- das erste Vergussmaterial (5; 15) einen thermischen Ausdehnungskoeffizienten (α_{VM1}) aufweist, welcher an den thermischen Ausdehnungskoeffizienten (α_{BD}) der Bonddrähte (4a, 4b; 14a, 14b) und an den thermischen Ausdehnungskoeffizienten (α_{TE}) des Trägerelementes (1; 10) angepasst ist.

2. Optoelektronische Bauelementanordnung nach Anspruch 1, wobei das erste Vergussmaterial (5; 15) einen thermischen Ausdehnungskoeffizienten α_{VM1} ≈ 18 - 19 ppm/K aufweist.

3. Optoelektronische Bauelementanordnung nach Anspruch 1, wobei das erste Vergussmaterial (5; 15) im ausgehärteten Zustand eine große Oberflächenrauheit besitzt.

4. Optoelektronische Bauelementanordnung nach Anspruch 1, wobei dass das erste Vergussmaterial (5; 15) eine schwarze Epoxyfüllmasse ist.

5. Optoelektronische Bauelementanordnung nach Anspruch 1, wobei das erste Vergussmaterial (5; 15) und das Material des Dammes (2; 12) aus dem gleichen Grundmaterial bestehen und lediglich eine unterschiedliche Viskosität aufweisen.

6. Optoelektronische Bauelementanordnung nach Anspruch 1, wobei das zweite Vergussmaterial (6; 16) den Damm-Innenbereich über dem ersten Vergussmaterial (5; 15) und dem optoelektronischen Bauelement (3; 13) vollständig ausfüllt.

7. Optoelektronische Bauelementanordnung nach Anspruch 1, wobei das optoelektronische Bauelement (3; 13) als Fotoelement oder Opto-ASIC ausgebildet ist, dessen strahlungsempfindliche Fläche vom Trägerelement (1; 10) weg orientiert ist.

8. Optoelektronische Bauelementanordnung nach Anspruch 7, wobei unmittelbar auf der strahlungsempfindlichen Fläche des Fotoelementes oder Opto-ASICs eine Glasplatte (19) angeordnet ist.

9. Verfahren zur Herstellung einer optoelektronischen Bauelementanordnung, wobei
- auf einem Trägerelement (1; 10) zunächst ein optoelektronisches Bauelement (3; 13) angeordnet und über Bonddrähte (4a, 4b; 14a, 14b) elektrisch kontaktiert wird,
- anschließend um das optoelektronische Bauelement (3; 13) ein geschlossener Damm (2; 12) auf dem Trägerelement (1; 10) aufgebracht wird und
- in den Damm-Innenbereich ein Verguss aus zwei Verguss-Materialien (5, 6; 15; 16) eingebracht wird, der das optoelektronische Bauelement (3; 13) umkapselt, wobei
- der Damm-Innenbereich oberhalb des optoelektronischen Bauelementes (3; 13) zumindest in einem Fensterbereich mit einem transparenten zweiten Vergussmaterial (6; 16) gefüllt wird und
- zum Einbringen des Vergusses zunächst ein erstes nichttransparentes Vergussmaterial (5; 15) in den Damm-Innenbereich bis zur Oberkante des optoelektronischen Bauelementes (3; 13) eingebracht wird, wodurch die Bonddrähte (4a, 4b; 14a, 14b) an ihrem trägerelementseitigen Ende vom ersten Vergussmaterial (5; 15) umgeben werden und
- dass ein erstes Vergussmaterial (5; 15) gewählt wird, das einen thermischen Ausdehnungskoeffizienten (α_{VM1}) aufweist, welcher an den thermischen Ausdehnungskoeffizienten (α_{BD}) der Bonddrähte (4a, 4b; 14a, 14b) und an den thermischen Ausdehnungskoeffizienten (α_{TE}) des Trägerelementes (1; 10) angepasst ist.

10. Verfahren nach Anspruch 9, wobei ein erstes Vergussmaterial (5; 15) gewählt wird, das einen thermischen Ausdehnungskoeffizienten α_{VM1} ≈ 18 - 19 ppm/K aufweist.

11. Verfahren nach Anspruch 9, wobei ein erstes Vergussmaterial (5; 15) gewählt wird, das im ausgehärteten Zustand eine große Oberflächenrauheit besitzt.

12. Verfahren nach Anspruch 9, wobei als erstes Vergussmaterial (5; 15) eine schwarze Epoxyfüllmasse gewählt wird.

13. Verfahren nach Anspruch 9, wobei das zweite Vergussmaterial (6; 16) in den vollständigen Damm-Innenbereich über dem ersten Vergussmaterial (5; 15) eingebracht wird.

14. Verfahren nach Anspruch 9, wobei das optoelektronische Bauelement (3; 13) elektrisch leitend mit Leiterbahnen im Trägerelement (1; 10) verbunden wird.

## Claims

1. Optoelectronic component array, comprising
- a carrier element (1; 10),
- an optoelectronic component (3; 13) which is disposed on the carrier element (1; 10) and is connected to lines in the carrier element (1; 10) via bonding wires (4a, 4b; 14a, 14b),
- an enclosed dam (2; 12) on the carrier element (1; 10) which surrounds the optoelectronic component (3; 13),
- a casting element which is disposed in the dam interior region, encapsulates the optoelectronic component (3; 13) and comprises two casting materials (5, 6; 15, 16), wherein
- the dam interior region above the optoelectronic component (3; 13) is filled at least in a window region with a transparent second casting material (6; 16), and
- the dam interior region is filled up to the upper edge of the optoelectronic component (3; 13) with a first non-transparent casting material (5; 15), and
- the bonding wires (4a, 4b; 14a, 14b) are surrounded by the first casting material (5; 15) at their carrier element end, and
- the first casting material (5; 15) has a thermal expansion coefficient (α_{VM1}) which is adapted to the thermal expansion coefficient (α_{BD}) of the bonding wires (4a, 4b; 14a, 14b) and to the thermal expansion coefficient (α_{TE}) of the carrier element (1; 10).

2. Optoelectronic component array according to claim 1, wherein the first casting material (5; 15) has a thermal expansion coefficient α_{VM1} ≈ 18 - 19 ppm/K.

3. Optoelectronic component array according to claim 1, wherein the first casting material (5; 15) has a high surface roughness in the cured state.

4. Optoelectronic component array according to claim 1, wherein the first casting material (5; 15) is a black epoxy filling compound.

5. Optoelectronic component array according to claim 1, wherein the first casting material (5; 15) and the material of the dam (2; 12) comprise the same basic material and merely have a different viscosity.

6. Optoelectronic component array according to claim 1, wherein the second casting material (6; 16) completely fills the dam interior region above the first casting material (5; 15) and above the optoelectronic component (3; 13).

7. Optoelectronic component array according to claim 1, wherein the optoelectronic component (3; 13) is configured as a photoelement or opto-ASIC, the radiation-sensitive surface of which is orientated away from the carrier element (1; 10).

8. Optoelectronic component array according to claim 7, wherein a glass plate (19) is disposed directly on the radiation-sensitive surface of the photoelement or of the opto-ASIC.

9. Method for producing an optoelectronic component array, wherein
- an optoelectronic component (3; 13) is disposed firstly on a carrier element (1; 10) and electrical contact is made with it via bonding wires (4a, 4b; 14a, 14b),
- subsequently an enclosed dam (2; 12) is mounted on the carrier element (1; 10) around the optoelectronic component (3; 13), and
- a casting element comprising two casting materials (5, 6; 15; 16) is introduced into the dam interior region which encapsulates the optoelectronic component (3; 13),
- the dam interior region above the optoelectronic component (3; 13) is filled at least in a window region with a transparent second casting material (6; 16), and
- in order to introduce the casting element, firstly a first non-transparent casting material (5; 15) is introduced into the dam interior region up to the upper edge of the optoelectronic component (3; 13), as a result of which the bonding wires (4a, 4b; 14a, 14b) are surrounded by the first casting material (5; 15) at their carrier element end, and
- a first casting material (5; 15) is chosen, which has a thermal expansion coefficient (α_{VM1}) which is adapted to the thermal expansion coefficient (α_{BD}) of the bonding wires (4a, 4b; 14a, 14b) and to the thermal expansion coefficient (α_{TE}) of the carrier element (1; 10) .

10. Method according to claim 9, wherein a first casting material (5; 15) is chosen, which has a thermal expansion coefficient α_{VM1} ≈ 18 - 19 ppm/K.

11. Method according to claim 9, wherein a first casting material (5; 15) is chosen, which has a high surface roughness in the cured state.

12. Method according to claim 9, wherein a black epoxy filling compound is chosen as first casting material (5; 15) .

13. Method according to claim 9, wherein the second casting material (6; 16) is introduced into the entire dam interior region above the first casting material (5; 15).

14. Method according to claim 9, wherein the optoelectronic component (3; 13) is connected in an electrically conductive manner to strip conductors in the carrier element (1; 10).

## Revendications

1. Ensemble à composant optoélectronique, constitué
- d'un élément support (1 ; 10) ;
- d'un composant optoélectronique (3 ; 13) qui est disposé sur l'élément support (1 ; 10) et est connecté par des fils de liaison (4a, 4b ; 14a, 14b) à des conducteurs situés dans l'élément support (1 ; 10),
- d'une barrière (2 ; 12) fermée qui est disposée sur l'élément support (1 ; 10) et entoure le composant optoélectronique (3 ; 13),
- d'une masse de scellement, disposée dans la zone intérieure de la barrière, qui enveloppe le composant optoélectronique (3 ; 13) et comprend deux matériaux de scellement (5, 6 ; 15, 16),
- la zone intérieure de la barrière qui est située au-dessus du composant optoélectronique (3 ; 13) étant remplie avec un deuxième matériau de scellement (6 ; 16) transparent, au moins dans une zone de fenêtre, et
- la zone intérieure de la barrière étant remplie avec un premier matériau de scellement (5 ; 15) non transparent, jusqu'au bord supérieur du composant optoélectronique (3 ; 13), et
- les fils de liaison (4a, 4b ; 14a, 14b) étant entourés par le premier matériau de scellement (5 ; 15) au niveau de leur extrémité du côté de l'élément support et
- le premier matériau de scellement (5 ; 15) présentant un coefficient de dilatation thermique (α_{VM1}) qui est adapté au coefficient de dilatation thermique (α_{BD}) des fils de liaison (4a, 4b ; 14a, 14b) et au coefficient de dilatation thermique (α_{TE}) de l'élément support (1 ; 10).

2. Ensemble à composant optoélectronique selon la revendication 1, dans lequel le premier matériau de scellement (5 ; 15) présente un coefficient de dilatation thermique α_{VM1} ≈ 18-19 ppm/K.

3. Ensemble à composant optoélectronique selon la revendication 1, dans lequel à l'état durci, le premier matériau de scellement (5 ; 15) présente une rugosité de surface élevée.

4. Ensemble à composant optoélectronique selon la revendication 1, dans lequel le premier matériau de scellement (5 ; 15) est une masse de remplissage époxy noire.

5. Ensemble à composant optoélectronique selon la revendication 1, dans lequel le premier matériau de scellement (5 ; 15) et le matériau de la barrière (2 ; 12) sont faits du même matériau de base et présentent seulement des viscosités différentes.

6. Ensemble à composant optoélectronique selon la revendication 1, dans lequel le deuxième matériau de scellement (6 ; 16) remplit complètement la zone intérieure de la barrière, au-dessus du premier matériau de scellement (5 ; 15) et du composant optoélectronique (3 ; 13).

7. Ensemble à composant optoélectronique selon la revendication 1, dans lequel le composant optoélectronique (3 ; 13) est réalisé sous forme de cellule photoélectrique ou de circuit optoélectronique ASIC, dont la surface sensible au rayonnement est orientée dans la direction opposée à l'élément support (1 ; 10) .

8. Ensemble à composant optoélectronique selon la revendication 7, dans lequel une plaque de verre (19) est disposée directement sur la surface sensiblement au rayonnement de la cellule photoélectrique ou du circuit optoélectronique ASIC.

9. Procédé de fabrication d'un ensemble à composant optoélectronique, dans lequel
- un composant optoélectronique (3 ; 13) est d'abord disposé sur un élément support (1 ; 10) et est mis en contact électrique par le biais de fils de liaison (4a, 4b ; 14a, 14b),
- ensuite, une barrière (2 ; 12) fermée est introduite sur l'élément support (1 ; 10), autour du composant optoélectronique (3 ; 13), et
- une masse de scellement, constituée de deux matériaux de scellement (5, 6 ; 15 ; 16), est introduite dans la zone intérieure de la barrière pour envelopper le composant optoélectronique (3 ; 13),
- la zone intérieure de la barrière qui est située au-dessus du composant optoélectronique (3 ; 13) étant remplie avec un deuxième matériau de scellement (6 ; 16) transparent, au moins dans une zone de fenêtre, et
- pour la mise en place de la masse de scellement, un premier matériau de scellement (5 ; 15) non transparent étant d'abord introduit dans la zone intérieure de la barrière, jusqu'au bord supérieur du composant optoélectronique (3 ; 13), de sorte que les fils de liaison (4a, 4b ; 14a, 14b) soient entourés au niveau de leur extrémité du côté de l'élément support par le premier matériau de scellement (5 ; 15) et
- un premier matériau de scellement (5 ; 15) présentant un coefficient de dilatation thermique (α_{VM1}) qui est adapté au coefficient de dilatation thermique (α_{BD}) des fils de liaison (4a, 4b ; 14a, 14b) et au coefficient de dilatation thermique (α_{TE}) de l'élément support (1 ; 10) étant choisi.

10. Procédé selon la revendication 9, dans lequel un premier matériau de scellement (5 ; 15) est choisi, lequel présente un coefficient de dilatation thermique α_{VM1} ≈ 18 - 19 ppm/K.

11. Procédé selon la revendication 9, dans lequel un premier matériau de scellement (5 ; 15) est choisi, lequel présente une rugosité de surface élevée à l'état durci.

12. Procédé selon la revendication 9, dans lequel une masse de remplissage époxy noire est choisie en tant que premier matériau de scellement (5 ; 15).

13. Procédé selon la revendication 9, dans lequel le deuxième matériau de scellement (6 ; 16) est introduit dans toute la zone intérieure de la barrière au-dessus du premier matériau de scellement (5 ; 15).

14. Procédé selon la revendication 9, dans lequel le composant optoélectronique (3 ; 13) est connecté de manière électriquement conductrice à des pistes conductrices situées dans l'élément support (1 ; 10).
